Europäisches Patentamt

European Patent Office

Office européen des brevets

(11) Publication number: **0 622 636 A1**

# EUROPEAN PATENT APPLICATION

(21) Application number: **93480052.5**

(22) Date of filing: **29.04.93**

(51) Int. Cl.5: **G01R 31/28**

(43) Date of publication of application:
**02.11.94 Bulletin 94/44**

(84) Designated Contracting States:
**DE FR GB**

(71) Applicant: **INTERNATIONAL BUSINESS MACHINES CORPORATION**
**Old Orchard Road**
**Armonk, N.Y. 10504 (US)**

(72) Inventor: **Lemoine, Jean-Marie**
**6, rue Aristide Briand**
**F-91240 St Michel Sur Orge (FR)**

(74) Representative: **Klein, Daniel Jacques Henri**
**Compagnie IBM France**
**Département de Propriété Intellectuelle**
**F-06610 La Gaude (FR)**

(54) Method for improving accuracy tester auto-calibration.

(57) In order to improve accuracy of memory access time measurements, a preliminary step of tester auto-calibration is performed. It consists to determine the propagation delays of the global transmission lines (13) which connect the output terminals of the tester (11) to the adequate I/O contact pads of the DUT (Device Under Test), typically a memory chip (12), each of said global transmission line being comprised of an ideal transmission line element: the coaxial cable (13-1) and an imperfect transmission line element: the probing head (13-2) which includes the contact probe (16-1). The novel method of auto-calibration includes the steps of:

- the DUT being removed (to have contact probes disconnected from the DUT contact pads), measure the reflection delay To for each open terminated global transmission line as standard;
- all the contact probes now being grounded, measure the reflection delay Ts for each short terminated global transmission line;
- determine a reflection coefficient G for each global transmission line that is given by $G = (R\text{-}Rc)/(R\text{+}Rc)$ wherein R is either the DUT input impedance (case the global transmission line is connected to a DUT receiver) or DUT output impedance (case the global transmission line is connected to a DUT driver) and Rc is the characteristic impedance of the coaxial cable of the global transmission line;
- compute the value of the real propagation delay Ti of each global transmission line using the following formula: $Ti = To\,(1\text{+}G)/4 + Ts\,(1\text{-}G)/4$;
- load the obtained values in the memory of the tester for automatic calibration of each of the global transmission lines.

EP 0 622 636 A1

FIG.1

The present invention relates to the testing of electronic components such as high performance bipolar and CMOS VLSI semiconductor chips embedding logic and memory arrays and more particularly to a method for accurately calibrating the global transmission lines between the tester output terminals and the I/O (Input/Output) contact pads of a product SRAM silicon chip to allow accurate memory address access time measurements thereof at the wafer level. The address access time (AAT) is a measurement of importance in the quality of SRAM memories because this parameter measures the speed at which the memory responds.

Prior to perform said access time measurements, state of the art testers need a preliminary step of auto-calibration to get rid of the propagation delays caused by the global transmission lines. By global transmission line it is meant the line which connects a tester output terminal and a chip I/O contact pad. A global transmission line essentially consists of two elements: first, a substantially ideal transmission line formed by a piece of a coaxial cable and second, a far from ideal transmission line due to the structure of the probing head. Unlike, the first element which has a relatively constant characteristic impedance, the second element formed by a space transformer and a contact probe terminated by a tip, has a variable characteristic impedance. Typically, the characteristic impedance of the coaxial cable is resistive (referred to hereafter as Rc) and its value is about 50 ohms. The characteristic impedance of the probing head is also resistive but may vary from 40 to 200 ohms. As known for those skilled in the art, all the tips of the probing head are arranged in a matrix that perfectly matches the chip contact pad array.

A classical tester autocalibration technique uses a single reflectometry measurement on each global transmission line let open on the side opposite to the tester. To that end, a signal is emitted by the tester and propagates along the line. The time needed to get the reflected signal back to the tester is measured. The propagation (or transmission) delay of the global transmission line is supposed to be half of the measured time so-called the reflection delay. Propagation delays of all global transmission lines are stored in a table and values of this table are used to correct driver and receiver signal edges. It is to be noted that modern semiconductor chips may include up to 1000 I/O contact pads. Consequently, the table construction is really a time consuming task. As a matter of fact, this technique provides a very rough approximation of the actual propagation delays because of the transmission line imperfections in the probing head mentioned above, which shift the edges of the reflected signal at random.

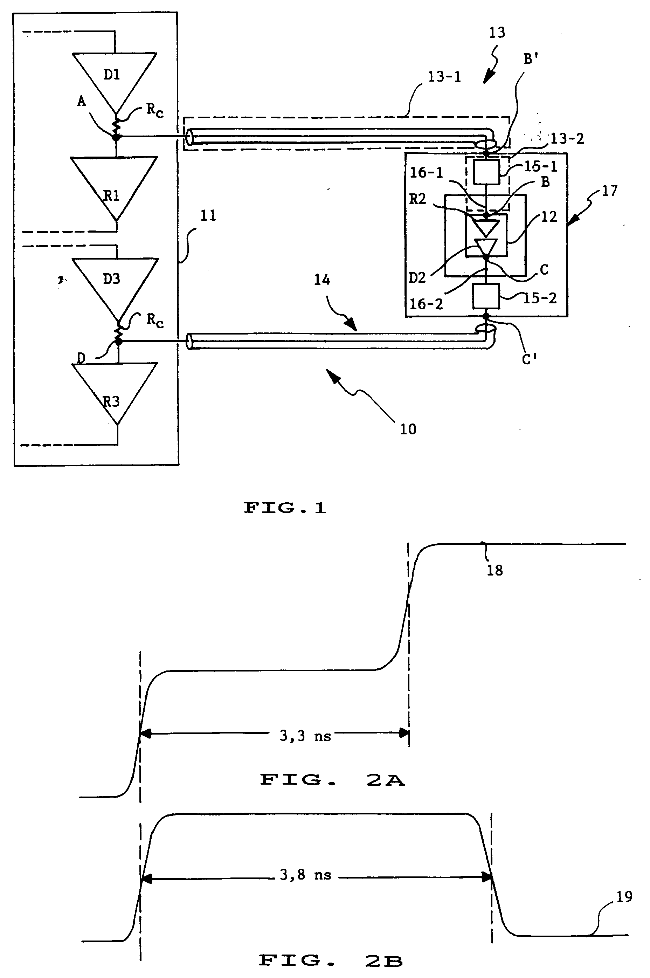

The basic principles of this standard approach will be now better understood by the following description given in conjunction with Fig. 1.

Fig. 1 illustrates very schematically the base elements at the test station referenced 10, including a tester 11 which generates the test signals, installed in a typical manufacturing facility. The electronic component to be tested is mounted on a testing fixture (not shown) as standard. For instance, should the DUT (Device Under Test) be a SRAM chip, the access time would correspond to the delay between the time the address (address bits) is applied to the appropriate input contact pads of the memory chip operating in the READ mode and the time the data (dataout bits) appears on the corresponding output contact pads. In other words, the access time is the elapsed time between a test signal generated by the tester is received by an input contact pad of the DUT (corresponding to an address bit) and the switching of the output contact pad triggered by this input contact pad. During the TEST operation, the chip is appropriately biased to adequate power supplies and to ground. Only the global transmission lines connected to address contact pads and to dataout contact pads will be activated, the other are inhibited. The procedure reads as explained below. Driver D1 of tester 11 sends a transition input test signal from an tester output terminal referred to as point A, to a determined input contact pad of the DUT referred to as point B, via a global transmission line 13 interconnecting said points A and B. Note that, at point B of the DUT, receiver R2 detects this test signal. Likewise, the tester 11 also incorporates a receiver R1 tied to point A, that is used to detect the test signal reflected at point B (case there is either an open or a short connection at point B). The signal which is output by the driver D2 of the DUT at point C, is sent back to receiver R3 of tester 11 at point D by another global transmission line 14. For sake of symmetry, in tester 11, a driver D3 is also connected to point D. Said driver D2 and receiver R2 are on-chip circuits implemented in the silicon for convenience. Generally speaking, the receiver R2 has two possible input impedance values: a low impedance value of about 50-60 ohms (i.e. close to said characteristic impedance mentioned above Rc) and a high impedance value of about 6 Kohms. The exact value of the receiver input resistance is determined by construction and thus does not vary during the TEST operation. On the other hand, driver D2 has two output impedance values that are very close e.g. 2 and 5 ohms depending the driver logic state. One resistor having an Rc value is inserted in each output of the tester drivers D1 and D3 to damp out the reflected wave signal caused by a global transmission line when it is terminated by an open and to damp out the signals emitted by chip drivers D2. As obvious for those skilled in the art, the test station 10 illustrated in Fig. 1 includes much more global transmission lines, in fact, at least as many as I/O contact pads are required to make the access time measurements. In TEST operation, the tester 11 actually measures the overall delay T needed for the signal to travel from point A to point D. This travel is seen by the tester as forming a loop. To get the DUT access time Ta for a determined loop, e.g. ABCD, i.e the propagation delay between points B and C, the propagation delays of the global transmission lines between points A and B, i.e. Ti(AB) and between points C and D, i.e. Ti(CD), have thus to be subtracted from the overall delay T mentioned above.

As currently practiced to day in advanced manufacturing facilities, where state of the art testers are employed, the said propagation delays of the above mentioned global transmission lines are determined from reflection delay measurements based on a standard reflectometry technique performed during the auto-calibration of the tester. This preliminary step is essential. To perform these reflection delay measurements, the DUT is removed from the testing fixture and a signal is sent by the tester, for instance with respect to the global transmission line 13, by tester driver D1. This signal is reflected at point B, because it is an open terminated global transmission line and the reflected signal is detected by tester receiver R1. The round trip ABA delay, i.e. the delay between the time the signal is emitted at point A, reflected in point B, and finally detected in point A, constitutes a reflection delay To the tester is also able to measure. The propagation delay for this global transmission line 13 with an open extremity is set to half of it. Same reasoning applies to other global transmission lines and this operation of reflection delay measurement is repeated for each of them with the DUT removed. When all the propagation delays have been determined, the results are stored in a memory of the tester in a table, to be subsequently used not only in the automatic computation of all the DUT access times but also to avoid undesired skew between the test signals generated by tester 11. This specific computation is performed by a dedicated microcomputer incorporated in the tester.

This propagation delay determination technique would be acceptable should the global transmission lines 13 and the like be "perfect" i.e. had a constant characteristic impedance. Unfortunately, this is not the case in the real manufacturing world when the reflection delay measurements are effected at the wafer level. Only the portion 13-1 of the global transmission line 13 located between points A and B' (see Fig. 1) formed by a coaxial cable is an ideal transmission line element and thus has a constant and accurate characteristic impedance value. On the contrary, the other portion 13-2 which consists of space transformer 15-1 and associated contact probe 16-1 (they are parts of the probing head 17 that is absolutely required to make the multiple contacts to the chip contact pad array), cannot be considered as a piece of an ideal transmission line with a determined constant characteristic impedance. Consequently, with such an imperfect transmission line element between points B and B' in the global transmission line 13, the propagation delay of a signal from point A to point B is no longer equal to half the round trip delay or reflection delay mentioned above.

Experiments conducted by applicant's inventor, have pointed out that, even with the best quality probing heads that are commercially available today, errors are always greater than 100 ps, but they can be much higher i.e. up to 400 ps when low quality probing heads are employed. Therefore, the major drawback of the standard autocalibration technique is its inherent inaccuracy in the determination of the propagation delays, mainly due to imperfections in the probing head, which in turn, result in inaccurate memory address access time measurements for SRAM chips.

In order to improve accuracy of memory access time measurements, a preliminary step of tester autocalibration is performed. It consists to determine the propagation delays of the global transmission lines which connect the tester output terminals to the adequate DUT I/O contact pads, each of said global transmission line being comprised of an ideal transmission line element (the coaxial cable) and an imperfect transmission line element (the probing head), and pursuant to the present invention, the following method is thus proposed. This method includes the steps of:

- the DUT being removed (to have contact probes disconnected from the DUT contact pads), measure the reflection delay To for each open terminated global transmission line as standard;
- all the contact probes now being grounded, measure the reflection delay Ts for each short terminated global transmission line;
- determine a reflection coefficient G for each global transmission line that is given by G = (R-Rc)/(R+Rc) wherein R is either the DUT input impedance (case the global transmission line is connected to a DUT receiver) or DUT output impedance (case the global transmission line is connected to a DUT driver) and Rc is the characteristic impedance of the coaxial cable of the global transmission line;
- compute the value of the real propagation delay Ti of each global transmission line using the following formula: Ti = To (1+G)/4 + Ts (1-G)/4;
- load the obtained values in the memory of the tester for automatic calibration of each of the global transmission lines.

4

In short, according to the present invention, the above problem caused by the inaccurate calibration of the tester, is solved by performing reflection delay measurements, not only on global transmission lines terminated by an open as standard, but also on said lines with their terminations shorted. In addition, a reflection coefficient which takes in account the the characteristic impedance of the coaxial cable and the impedance of the DUT to be tested as seen by the global transmission line (DUT receiver input impedance or DUT driver output impedance). These two measurements are weighted by this reflection coefficient and then linearly combined to finally result in an excellent approximation of the real propagation delays. DUT access times can now be accurately determined.

Therefore, it is a primary object of the present invention to improve the standard technique of determining propagation delays by a reflectrometry based technique for tester autocalibration.

It is another object of the present invention to perform the measurement of the reflection delays by a reflectrometry based technique on global transmission lines successively terminated by an open and by a short.

It is another object of the present invention to perform the measurement of the reflection delays by a reflectrometry based technique that take in account the impedance seen by the global transmission lines.

It is still another object of the present invention to provide a method for autocalibrating testers that permits an accurate determination of access times of memory chips.

The novel features believed to be characteristic of this invention are set forth in the appended claims. The invention itself, however, as well as other objects and advantages thereof, may best be understood by reference to the following detailed description of an illustrated preferred embodiment to be read in conjunction with the accompanying drawings.

Fig. 1 shows a schematic block diagram illustrating two global transmission lines which connect a high performance tester and a DUT consisting of a SRAM chip.

Figs. 2a and 2b show the waveforms of the emitted signal and the reflected signal as seen by a receiver of the tester in cases of open and shorted global transmission lines respectively.

To facilitate reader's understanding the base elements of the standard technique of measuring propagation delays by reflectrometry will briefly be introduced. If a global transmission line is not perfect, the propagation delay thru the line is no longer a constant intrinsic property thereof. Propagation delay of an imperfect line varies with a number of parameters such as: the signal rise/fall time, the real impedance value of the load which terminates the global transmission lines, ...so that the round trip delay is no longer equal to twice the single travel delay. Consequently, the propagation delay is no longer half of the reflection delay. Fortunately, the delay variation laws as a function of these parameters can be understood and used for compensation.

Experimental works conducted by applicant's inventor have demonstrated that, if errors generated by resistive losses are negligible, which is the most frequent case, as it will be explained hereafter and if the DUT drivers and the tester drivers have similar performance, i.e. there is no significant technological gap therebetween, the real propagation delay Ti of a global transmission line can be accurately calculated from the following formula:

$$Ti = To\,(1+G)/4 + Ts(1-G)/4 \qquad (1)$$

wherein

To is the reflection delay of a global transmission line with an open termination. Ts is the reflection delay of the subject global transmission line with a short termination. G is the reflection coefficient of the subject global transmission line, and can be calculated from formula (2):

$$G = (R\text{-}Rc)/(R+Rc) \qquad (2)$$

wherein

R is either the input impedance or the output impedance of the DUT depending the global transmission line is connected to a receiver or to a driver, and Rc is the coaxial cable characteristic impedance. R being assumed to be purely resistive (the case where said impedance R is not resistive will be discussed later). Note that, because the driver has a very low output impedance (in the 2-5 ohms range) it can be approximated to zero, thus leading to a G value equals to -1. For the DUT receivers, the reflection coefficient G may also be approximated to zero when the input impedance is close to the characteristic impedance Rc and to one when it has its high value of about 6 Kohms. For sake of simplicity, this reflection coefficient G can be set at the same value for all the receivers of the DUT. For instance, typically the high value of receiver input impedance may vary from 5.9 to 6.2 Kohms for all the receivers of a same chip.

Same reasoning applies to reflection coefficient G as far as the DUT drivers are concerned.

As a result, the real propagation delay Ti is computed using a linear combination of both reflection delay measurements, further taking in account either the DUT input impedance in case the global transmission line is connected to a receiver or the DUT output impedance in case the global transmission line is connected to a driver.

With high performance testers, the intrinsic measurement error that is introduced by this calibration method is lower than 10 ps. In fact, this residual error essentially results from the intrinsic tester measurement inaccuracy.

The maximum timing Te error introduced by resistive losses can be approximated using formula (3):

$$Te = r\ Tt/4Rc \qquad (3)$$

wherein

r is the serial resistance of the global transmission line, Tt the signal rise or fall time and Rc is the coaxial cable characteristic impedance.

The errors generated by resistive losses can be considered to be negligible as far as r is inferior to 1 ohm. This is the the general case when high quality probing heads (they are currently commercially available) are used. For values ranging from 1 ohm to 5 ohms, the above method is still valid, although accuracy decreases rapidly. Using low quality probing heads where r is above 5 ohms, makes the present method inapplicable.

On the other hand, if the DUT input or output impedance is not purely resistive, and cannot be represented any longer by resistor R, but by an impedance Z (generally Z has a significant capacitive component), measurements on open and shorted global transmission lines are in turn no longer sufficient to accurately compute the propagation delays. This problem could be probably solved by performing reflection measurements directly on the DUT I/O contact pads, but the present method would be no longer of interest.

Let us now give details as to the practical implementation of the above described method of the present invention.

According to a first significant feature of the present invention, the first step consists in the preliminary determination of the receiver input resistance values for all DUT inputs and the driver output resistance values for all DUT outputs. However, note that theoretical values may be sufficient. For example, these values can be supplied by the DUT design engineer from ASTAP simulations. As a matter of fact, most of the time, accuracy on the values of these resistances is not really critical.

Then, the reflection coefficient G is computed using formula (2) for each of the global transmission line. Generally, the same reflection coefficient G can be used for for all receivers of the DUT in a good approximation. Same reasoning applies to the reflection coefficient G for the DUT drivers.

Next, the DUT is removed from the testing fixture and the reflection delay To for open terminated global transmission lines is measured for each of them.

Now, according to another significant feature of the present invention, the DUT is replaced by a test device shortening all probe tips and connecting them to the ground potential. To that end, a copper plate connected to the ground is firmly applied against all contact probe tips for instant shortening or is inserted between the tips and the chip contact pads (the chip is no longer connected to the power supplies but still remains connected to ground). It is recommended to perform a thorough DC test to verify that all global transmission lines are effectively grounded. Then, the reflection delay Ts for short terminated global transmission lines is measured for each of them.

Next, the propagation delay Ti of each global transmission line is computed using formula (1).

Finally, the values of said propagation delays Ti are loaded in the tester memory. For a determined loop e.g. ABCD (Fig. 1), having an overall delay T, the propagation delays Ti(AB) and Ti(CD) respectively corresponding to paths AB and CD, are subtracted therefrom, to provide the desired access time Ta for a specific address bit. Most of the above described steps can be easily automated when advanced state of the art testers are used in the manufacturing facility. Depending upon quality of the probing head, the expected accuracy improvement ranges from 100 ps to 400 ps

The following TABLE gives a sample of the practical values referred to as To and Ts that have been respectively obtained by reflection delay measurements effected on twelve global transmission lines referenced L1 to L12, successively opened and shorted at their extremity. A high quality commercially available probing head 17 was used for these experiments. Differences between the measurements range from 348 ps (L2) to 500 ps (L1). All values are given in ns.

6

TABLE

| NAME | To | Ts |
|------|-------|-------|
| L1 | 3.299 | 3.799 |
| L2 | 3.361 | 3.709 |
| L3 | 3.333 | 3.714 |
| L4 | 3.312 | 3.752 |
| L5 | 3.282 | 3.678 |
| L6 | 3.290 | 3.675 |
| L7 | 3.325 | 3.708 |
| L8 | 3.389 | 3.748 |
| L9 | 3.320 | 3.723 |
| L10 | 3.237 | 3.728 |
| L11 | 3.415 | 3.838 |
| L12 | 3.337 | 3.801 |

For instance, if global transmission line L1 is terminated by an input impedance R of high value ($G \approx 1$) the propagation delay will be half of the measured reflected delay To which is equals to 3.299, i.e. to about 1.650 ns (the result that would have been obtained by the prior art method). If this line L1 is terminated by an input impedance R approximately equal to Rc ($G = 0$), the propagation delay Ti will be a fourth of the sum of reflected delays To and Ts, i.e. Ti = (3.299 + 3.799)/4, about 1.775 ns. Finally, if this line L1 is terminated by an output impedance R close to zero ($G \approx -1$), the propagation delay Ti will be half of the reflected delay Ts, which is equal to 3.799/2, i.e. about 1.900 ns. In the latter case, should the measurement would have been completed using To only as practiced in the prior art method, that would have given a propagation delay of 1.650 ns instead of 1900 ns. As a final result, an error of about 250 ps would have occurred.

The present invention finds application to a large variety of memories such as RAMs (including SRAMs and DRAMs) and ROMs (including flash memories).Note that, the DUT could be an electronic module packaging a plurality of memory chips instead of a single SRAM chip.

## Claims

1. An improved method for tester auto-calibration consisting in the determination of the propagation delays of the global transmission lines (13) that connect the output terminals of a tester (11) and the contact pads of a product memory chip (12) characterized in that it includes the steps of:
   - the chip being removed (to have contact probes disconnected from the chip contact pads), measure the reflection delay To for each open terminated global transmission line as standard;
   - all the contact probes now being grounded, measure the reflection delay Ts for each short terminated global transmission line;
   - determine a reflection coefficient G for each global transmission line that is given by G = (R-Rc)/-(R + Rc) wherein R is either the DUT input impedance (case the global transmission line is connected to a DUT receiver) or DUT output impedance (case the global transmission line is connected to a DUT driver) and Rc is the characteristic impedance of the coaxial cable of the global transmission line;
   - compute the value of the real propagation delay Ti of each global transmission line using the following formula: Ti = To (1 + G)/4 + Ts (1-G)/4;
   - load the obtained values in the memory of the tester for automatic calibration of each of the global transmission lines.

2. The method of claim 1 wherein the said chip is replaced by an electronic module including a plurality of memory chips and said contact pads are replaced by contact pins.

FIG.1

3,3 ns

FIG. 2A

3,8 ns

FIG. 2B

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | US-A-4 827 437 (BLANTON)<br>* column 5, line 32 - line 41; claim 14; figures 3,7,8 *<br>--- | 1 | G01R31/28 |
| Y | GB-A-2 258 051 (GENRAD LTD.)<br>* abstract; claim 4; figures 6,9 *<br>--- | 1 | |
| A | EP-A-0 466 939 (ADVANTEST CORPORATION)<br>* abstract; figure 3 *<br>----- | 1 | |

| | TECHNICAL FIELDS SEARCHED (Int. Cl.5) |
|---|---|
| | G01R<br>G06F |

The present search report has been drawn up for all claims

| Place of search | Date of completion of the search | Examiner |
|---|---|---|
| BERLIN | 18 OCTOBER 1993 | KEMPEN P. |

EPO FORM 1503 03.82 (P0401)